# FASCICULE DE BREVET EUROPEEN

(11) **EP 2 209 211 B1**
(45) Date de publication et mention de la délivrance du brevet: **24.10.2018**
(21) Numéro de dépôt: 09354052.4
(22) Date de dépôt: 04.12.2009
(51) Int. Cl.: H03K 17/082, H03K 17/567

(54) **Commutateur statique haute tension**
Statischer Hochspannungsschalter
Static high volatge switch

(30) Priorité: 20.01.2009 FR 0900242
(43) Date de publication de la demande: 21.07.2010
(73) Titulaire: Crouzet Automatismes, 26000 Valence (FR)
(72) Inventeur: Girot, Dominique, 38050 Grenoble Cedex 09 (FR); Carton, Hervé, 38050 Grenoble Cedex 09 (FR)
(74) Mandataire: GIE Innovation Competence Group

(56) Documents cités:
- EP-A- 0 599 605
- FR-A- 2 794 890
- JP-A- 2007 221 473
- US-A1- 2008 074 820
- US-B1- 6 404 173

## Description

### DOMAINE TECHNIQUE DE L'INVENTION

L'invention est relative à un commutateur statique haute-tension destiné à être connecté en série avec une charge à protéger. Le commutateur comporte au moins deux moyens de commutation électrique connectés en parallèle, des moyens de mesure destinés à mesurer une tension électrique aux bornes des moyens de commutation électrique et un courant principal circulant dans la charge. Le commutateur comporte aussi des moyens de commande délivrant un signal de commande pour agir sur l'ouverture et la fermeture des moyens de commutation électrique en fonction de la valeur du courant électrique principal traversant la charge.

### ETAT DE LA TECHNIQUE ANTERIEURE

Les composants de puissance utilisés pour assurer la fonction de commutation électrique sont largement employés notamment dans le domaine aéronautique. A titre d'exemple, ces composants peuvent être des transistors de type MOSFET, IGBT, BIPOLAIRES, JFET, en silicium ou en carbure de silicium. Les dispositifs de commutation utilisés comme commutateur statique sont appelé par la suite SSPC (Solid State Power Controler) ou CDS (Contacteur Disjoncteur Statique).

Un commutateur statique de type SSPC est adapté pour fonctionner généralement suivant deux modes de fonctionnement.

Un premier mode de fonctionnement correspond au cas où le courant électrique comporte une valeur inférieure ou égale au courant nominal In de fonctionnement (I≤In). Le commutateur de type SSPC doit alors présenter une faible chute de tension. Cette chute de tension au bornes du disjoncteur SSPC est appelée par la suite tension de déchet. Le fait de réduire la tension de déchet permet de réduire les pertes par effet joule dans le disjoncteur. En outre la réduction de la tension de déchet permet d'augmenter la quantité d'énergie transférée à la charge. Un maximum d'énergie peut être transféré à la charge lorsque la tension de déchet est minimale. A titre d'exemple, la tension de déchet maximale acceptable peut être égale à 0,4V

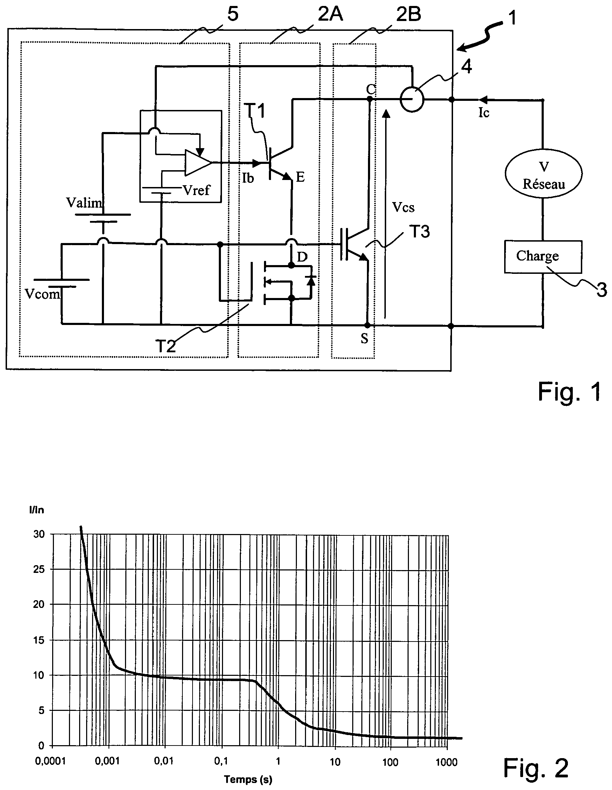

Un second mode de fonctionnement correspond au cas où le courant électrique comporte une valeur supérieure au courant nominal de fonctionnement (I>In). Le commutateur de type SSPC est généralement capable de supporter un fort courant (I>In) pendant un temps d'autant plus court que la valeur du courant est élevée. Ce sur-courant, et le temps pendant lequel il est appliqué est donné par la courbe de disjonction telle que représentée à la figure 2. A titre d'exemple, la tension de déchet maximale acceptable peut être égale à 2V.

L'utilisation de transistor de type IGBT dans des disjoncteurs SSPC est connue. Son utilisation est plus particulièrement dédiée à des applications hautes tensions. Dans des conditions particulières d'utilisation, notamment lorsque la température est environ égale à 150°C et que le courant est inférieur au dixième du courant maximum, alors la tension de déchet des transistors de type IGBT ne peut pas être inférieure à 0,85 volt. Cette tension de déchet est plus proche de 1,15V dans les conditions normales de fonctionnement. Ceci oblige à augmenter l'efficacité des dispositifs de refroidissement qui sont alors lourds et encombrants. Ceci est un handicap pour l'utilisation des commutateurs de type SSPC dans l'aéronautique.

Pour répondre à certains problèmes, des solutions connues telles décrites dans le document FR2680925 , utilisent deux transistors connectés en parallèle. Le document FR2680925 décrit l'utilisation d'un premier transistor de type bipolaire connecté en parallèle avec un transistor de type IGBT. Avantageusement, ce type de montage présente une tension de déchet faible. En outre, ce type de montage présent notamment l'inconvénient d'avoir un faible gain. En outre, il est souhaitable de saturer le transistor bipolaire pour bénéficier d'une tension de déchet faible. Ceci implique de dé-saturer ledit transistor bipolaire lors de son ouverture pour couper le courant. Cette dernière opération augmente le temps de fonctionnement pour la commutation. L'ensemble constitué d'un transistor de type IGBT et d'un transistor bipolaire connectés en parallèle ne peut donc pas s'ouvrir rapidement en cas de surcourant.

De l'état de la technique est également connu de US6404173B1 et FR2794890A.

### EXPOSE DE L'INVENTION

L'invention vise donc à remédier aux inconvénients de l'état de la technique, de manière à proposer un commutateur statique haute tension à faibles pertes énergétique.

L'invention est défini par les revendications d'appareils 1 et 2 qui portent chacune sur une solution alternative. Le commutateur statique haute tension selon l'invention est caractérisé en que l'état de conduction du premier moyen de commutation électrique dépend à la fois du courant principal circulant dans la charge, d'un courant de commande, d'une tension de commande délivrés par les moyens de commande, et du gain du premier moyen de commutation électrique.

Le premier moyen de commutation comporte un premier transistor de type bipolaire connecté en série avec un second transistor à effet de champ, l'émetteur du premier transistor de type bipolaire étant relié au drain du second transistor à effet de champ.

Avantageusement, les moyens de commande sont connectés à la base du premier transistor de type bipolaire pour y délivrer un courant de commande régulé, ledit courant de commande régulé étant dépendant à la fois d'une tension de référence, du courant électrique principal et d'une tension de déchet mesurée entre le collecteur du transistor bipolaire et la source du second transistor à effet de champ. Les moyens de commande sont connectés à la grille du second transistor à effet de champ pour y délivrer un signal de commande.

Selon un mode préférentiel de réalisation de l'invention, le premier moyen de commutation comporte un transistor de type ESBT®.

Avantageusement, les moyens de commande sont connectés à la base du transistor de type ESBT® pour y délivrer un courant de commande régulé, ledit courant de commande régulé étant dépendant à la fois d'une tension de référence, du courant électrique principal et d'une la tension de déchet mesurée entre le collecteur et la source dudit transistor. Les moyens de commande sont connectés entre la base et la source dudit transistor pour y délivrer un signal de commande.

Selon les mode de développement de l'invention, le second moyen de commutation électrique comporte un troisième transistor.

Avantageusement, le troisième transistor est un transistor bipolaire à grille de type IGBT, les moyens de commande sont connectés à la grille dudit transistor bipolaire à grille de type IGBT pour y délivrer un signal de commande.

Avantageusement, le troisième transistor est un transistor à effet de champ de type MOSFET, les moyens de commande sont connectés à la grille dudit transistor à effet de champ pour délivrer un signal de commande.

### BREVE DESCRIPTION DES FIGURES

D'autres avantages et caractéristiques ressortiront plus clairement de la description qui va suivre de modes particuliers de réalisation de l'invention, donnés à titre d'exemples non limitatifs, et représentés aux dessins annexés sur lesquels :
la figure 1 représente un schéma électrique d'un commutateur statique haute tension selon un premier mode préférentiel de réalisation de l'invention ;
la figure 2 représente une courbe de disjonction d'un commutateur statique selon la figure 1 ;
la figure 3A représente les courbes de la tension de déchet des moyens de commutation d'un commutateur statique selon la figure 1 ;
la figure 3B représente une courbe de la tension de déchet d'un commutateur statique selon la figure 1 ;
la figure 4 représente une courbe du courant de commande d'un commutateur statique selon la figure 1 ;
la figure 5 représente un schéma électrique d'un commutateur statique haute tension selon un second mode préférentiel de réalisation de l'invention ;
La figure 6 représente une variante de réalisation du premier et second mode préférentiel de réalisation selon les figures 1 et 5 ;
La figure 7 représente une courbe de la tension de déchet d'un commutateur statique selon la figure 6.

### DESCRIPTION DETAILLEE D'UN MODE DE REALISATION

Le dispositif de commutation statique haute tension 1 selon l'invention, comporte au moins deux moyens de commutation électrique 2A, 2B connectés en parallèle. Lesdits au moins deux moyens de commutation électrique sont de technologie différente. Autrement dit, les moyens de commutation électrique respectivement connectés en parallèle sont différents l'un de l'autre. Le dispositif de commutation statique est destiné à être connecté à une charge 3. Des moyens de mesure 4 sont destinés à mesurer une tension électrique Vcs aux bornes des moyens de commutation électrique 2A, 2B et un courant principal Ic circulant dans la charge 3. Le moyens de mesure 4 sont reliés à des moyens de commandes 5.

De manière connue, les moyens de commande 5 sont destinés à délivrer un signal de commande Vcom, Ib pour agir sur l'ouverture et la fermeture des moyens de commutation électrique 2A, 2B en fonction de la valeur du courant électrique principal Ic traversant la charge 3. Ainsi, l'état de conduction du premier moyen de commutation électrique 2A dépend du courant principal Ic circulant dans la charge 3 et du gain Hfe du premier moyen de commutation électrique 2A.

Selon un mode de réalisation de l'invention, les moyens de commande 5 sont connectés au premier moyen de commutation électrique 2A de manière à ce que l'état de conduction dudit premier moyen de commutation électrique 2A dépend à la fois d'un courant de commande Ib et d'une tension de commande Vcom délivrés par les moyens de commande 5.

Selon un premier mode préférentiel de réalisation de l'invention représenté sur la figure 1, Le premier moyen de commutation électrique 2A comporte un montage de type CASCODE comprenant deux transistors T1, T2. Un premier transistor T1 de type bipolaire est connecté en série avec un second transistor T2 à effet de champ (type MOSFET). L'émetteur E du premier transistor de type bipolaire T1 est relié au drain D du second transistor à effet de champ T2. Les moyens de commande 5 sont destinés à délivrer un signal de commande Vcom à la grille du second transistor à effet de champ T2.

Selon ce mode préférentiel de réalisation de l'invention, le troisième transistor T3 est de préférence un transistor bipolaire à grille de type IGBT.

Les moyens de commande 5 sont reliés électriquement aux transistors T1, T2, T3. En effet, les moyens de commande 5 sont connectés à la base du premier transistor de type bipolaire T1 pour y délivrer un courant de commande régulé Ib. Ledit courant de commande Ib régulé est dépendant à la fois d'une tension de référence Vref, du courant électrique principal Ic et d'une tension de déchet Vcs mesurée entre le collecteur C du premier transistor de type bipolaire T1 et la source S du second transistor à effet de champ de type MOSFET T2. Les moyens de commande 5 sont aussi connectés à la grille du second transistor à effet de champ de type MOSFET T2 pour y délivrer un signal de commande Vcom. Les moyens de commande 5 sont connectés à la grille dudit transistor bipolaire à grille de type IGBT pour y délivrer un signal de commande Vcom.

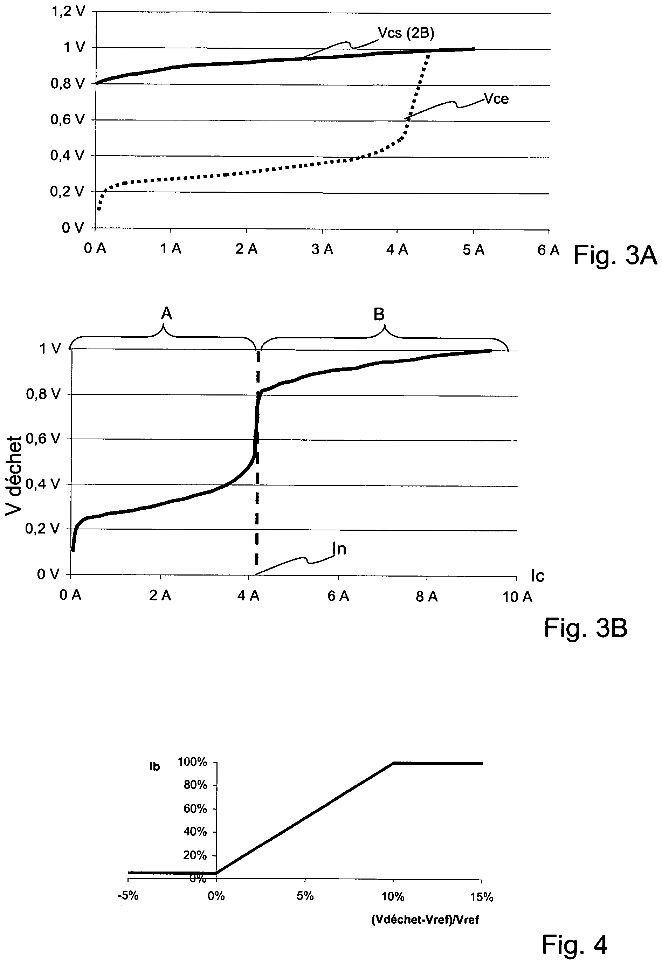

Le principe de fonctionnement du second moyen de commutation électrique 2B comprenant le troisième transistor T3 est le suivant. Le second moyen de commutation électrique 2B est conducteur quand les moyens de commande 5 délivrent une tension de commande Vcom. Comme représenté sur la figure 3A, sa tension de déchet Vcs pouvant atteindre plus de 1 Volt est élevée mais ledit second moyen de commutation 2B a l'avantage de pouvoir conduire un courant principal Ic de grande valeur, notamment supérieur au courant nominal.

Le principe de fonctionnement du premier moyen de commutation électrique 2A comprenant le montage CASCODE est différent de celui du second moyen de commutation électrique 2B. L'état de conduction du premier moyen de commutation électrique 2A (bloqué, limité ou saturé) dépend à la fois du courant principal Ic circulant dans la charge 3, du courant de commande Ib, de la tension de commande Vcom, et du gain Hfe du transistor T1 de type bipolaire.

Le premier moyen de commutation électrique 2A est conducteur quand une tension de commande Vcom est présente et qu'un courant de commande Ib alimente la base du premier transistor T1 de type bipolaire. Le transistor T2 de type MOSFET est conducteur si la tension de commande Vcom est appliquée. Il se comporte alors comme une résistance ayant une valeur donnée Ron. La valeur de résistance interne Ron est à titre d'exemple de 0,08 ohm dans ce premier mode de réalisation.

Comme représenté sur la figure 3A, à titre d'exemple de réalisation, la tension de déchet Vce du premier moyen de commutation électrique 2A est alors comprise entre 0,1V et 0,5V et peut être considérée comme faible. Pour des courants électriques supérieurs au courant nominal In (In= 4A), la tension de déchet tend à croitre très rapidement.

Le transistor T1 de type bipolaire a un mode de fonctionnement comme décrit ci-dessous.

Le transistor T1 de type bipolaire est saturé si le courant de commande Ib est supérieur au rapport Ic/Hfe entre le courant principal Ic et le gain Hfe. A titre d'exemple, selon le mode de réalisation de l'invention, la tension de déchet Vce peut être alors inférieure à 0,3 volts.

Le transistor T1 de type bipolaire est conducteur si le courant de commande Ib est à la fois supérieur à 0 et inférieur mais au rapport Ic/Hfe entre le courant principal et le gain Hfe. La tension de déchet Vce tend alors à augmenter.

Le transistor T1 de type bipolaire est bloqué si le courant de commande Ib est égal à 0.

Une solution pour maintenir une tension de déchet Vce la plus faible possible, consisterait ainsi à maintenir saturé le premier transistor T1 de type bipolaire. Pour cela, il serait alors nécessaire d'augmenter la valeur du courant de commande Ib. Cette solution ne serait pas économique car il faudrait dimensionner le circuit électrique afin qu'il soit apte à fournir un courant de commande Ib maximum suffisant pour que la régulation puisse supporter les courants principaux Ic supérieurs au courant nominal In.

Selon un mode de fonctionnement des modes de réalisation de l'invention, il a été retenu de travailler avec une tension de déchet Vce constante, en régulant le courant Ib. On augmente le courant de commande Ib quant la tension de déchet Vce est supérieure à une tension de référence Vref, et on diminue Ib quand la tension de déchet Vce est inférieure à la tension de référence Vref. Comme représenté sur la figure 4, la valeur du courant de commande Ib est bornée entre un minimum et un maximum. Une première valeur minimale est très faible pour maintenir le premier transistor T1 de type bipolaire en conduction même si la charge 3 ne consomme aucun courant principal Ic. Une seconde valeur maximale est suffisante pour que la régulation puisse fonctionner jusqu'à un courant nominal In, mais pas au-delà.

Ainsi, dans le mode de fonction de l'invention, le courant de commande Ib suit une variation proportionnelle à la valeur du courant principal Ic. Le courant de commande Ib est maintenu légèrement inférieur au rapport Ic/Hfe entre le courant principal et le gain Hfe. Le premier transistor T1 de type bipolaire n'est alors pas complètement saturé.

Selon un mode particulier de réalisation, avec un courant nominal In sensiblement égal à 4 Ampères, la tension de déchet utilisée pour la régulation pourrait être choisie entre 0,25V et 1V. Ces valeurs sont définies ainsi : Le minimum de 0,25V est la plus faible valeur que peuvent garantir les transistors T1, T2 du montage CASCODE, et la plus forte valeur (1V) est celle que pourrait garantir le troisième transistor T3 de type IGBT.

Le choix de la valeur de la tension de déchet Vce pour la régulation est déterminé en fonction des pertes électriques totales lorsque le courant principal Ic est égal au courant nominal In. On cherche à optimiser le fonctionnement du dispositif en minimisant ces pertes électriques totales. Lorsque le courant principal Ic est égal ou inférieur au courant nominal In, il n'y a aucun courant dans le transistor T3 de type IGBT. Les pertes électriques totales dans le premier moyen de commutation 2A se composent d'une part de pertes électriques directes dans les transistors T1, T2 du montage CASCODE et d'autre part de pertes électriques dues à la commande du premier transistor T1 de type bipolaire. Les pertes électriques directes dans le montage CASCODE sont égales au produit de la tension de déchet Vce du premier moyen de commutation 2A par le courant principal Ic (Vce x Ic). Les pertes électriques dues à la commande du premier transistor T1 de type bipolaire sont égales au produit de la tension d'alimentation Valim du circuit générant le courant de commande Ib à la base du premier transistor T1 de type bipolaire par le courant de commande Ib (Valim x Ib).

Ainsi, si on cherche à baisser la tension de déchet Vce en augmentant le courant commande Ib, alors les pertes électriques dues à la commande du premier transistor T1 de type bipolaire vont croitre. Autrement dit, en baissant les pertes électriques directes, on tend à augmenter les pertes électriques dues à la commande. Il existe donc une valeur optimale, où les pertes électriques totales sont les plus faibles. A titre d'exemple de réalisation non limitatif, la régulation de la tension de déchet Vce du premier moyen de commutation 2A est comprise entre 0,3 et 0,4 V.

Le fonctionnement des moyens de commande 5 est le suivant.

Comme représenté sur le figure 3B, lorsqu'un courant principal Ic traversant la charge 3 est inférieur à la valeur du courant nominal In (zone A), ledit courant principal Ic circule alors principalement dans le premier moyen de commutation 2A. La valeur minimale de la tension de déchet Vcs du troisième transistor T3 empêche le courant de circuler dans le dit troisième transistor T3.

Comme représenté sur le figure 3B, lorsqu'un courant principal Ic traversant la charge 3 est compris entre la valeur du courant nominal In et un courant de court-circuit Icc (zone B), ledit courant principal Ic circule alors à la fois dans le premier et le second moyens de commutation 2A, 2B. La répartition du courant principal Ic dans les moyens de commutation électrique 2A, 2B se fait de la façon suivante : un courant électrique de valeur environ égale à celle du courant nominal In circule dans le premier moyen de commutation 2A et un courant de valeur environ égale à la différence entre le courant principal Ic et le courant nominal In (Ic - In) dans le second moyen de commutation 2B.

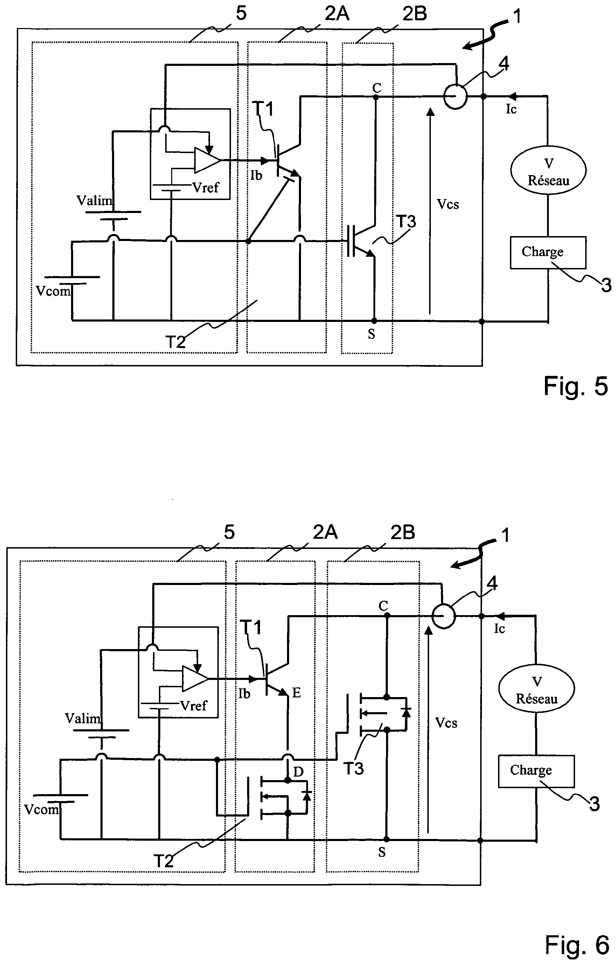

Selon un second mode préférentiel de réalisation de l'invention représenté sur la figure 5, le premier transistor T1 de type bipolaire connecté en série avec le second transistor T2 de type MOSFET selon un montage CASCODE soient avantageusement remplacés par un transistor de type ESBT® (Emitter-Switched Bipolar-Transistors). Le premier moyen de commutation électrique 2A comprend alors un seul transistor de type ESBT® qui intègre alors les fonctionnalités du premier et second transistor T1, T2. Les moyens de commande 5 sont connectés à la base du transistor de type ESBT® pour y délivrer un courant de commande Ib régulé. Ledit courant de commande Ib régulé est alors dépendant à la fois d'une tension de référence Vref, du courant électrique principal Ic et d'une la tension de déchet Vcs mesurée entre le collecteur C et la source dudit transistor. Les moyens de commande 5 sont connectés entre la base et la source dudit transistor pour y délivrer un signal de commande Vcom.

Comme le montage CASCODE décrit ci-dessus, le principe de fonctionnement du transistor de type ESBT® est le suivant, il conduit quand la tension de commande Vcom est présente, est que un courant de commande Ib lui est fourni. Son état de conduction (bloqué, limité ou saturé) dépend de la valeur du courant principal Ic, du courant de command Ib, et du gain Hfe dudit transistor.

Selon une variante de réalisation des deux modes préférentiels de réalisation de l'invention représentée sur la figure 6. Le premier moyen de commutation éléctrique 2A comporte soit un montage CASCODE ayant un premier et second transistors T1, T2 soit un transistor de type ESBT®. Le second moyen de commutation éléctrique 2B comporte un troisième transistor à effet de champ de type MOSFET T3 au lieu d'un transistor de type IGBT.

Les moyens de commande 5 sont connectés à la grille dudit transistor à effet de champ pour délivrer un signal de commande Vcom. La commande du premier moyen de commutation électrique est identique à celle des deux modes préférentiels décrits ci-dessus.

Le troisième transistor T3 de type MOSFET du second moyen de commutation 2B est conducteur si la tension de commande Vcom est appliquée. Il se comporte alors comme une résistance interne ayant une valeur donnée Ron. La valeur de résistance Ron est à titre d'exemple de 0,12 ohm dans cet exemple de réalisation.

Ledit transistor a un comportement linéaire.

Le fonctionnement des moyens de commande est le suivant.

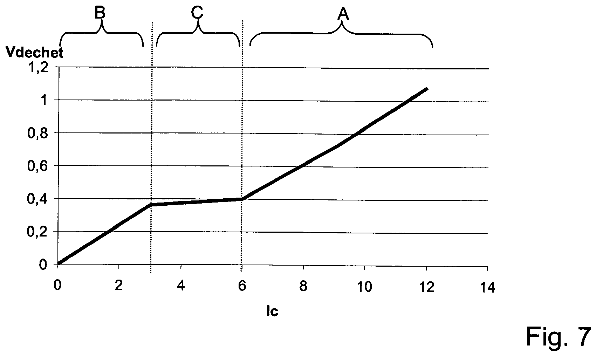

Comme représenté sur la figure 7 , lorsque la tension de déchet Vce est régulée entre 0 et 0,3V (Zone B), l'intégralité du courant principal Ic circule dans le premier moyen de commutation 2A.

Comme représenté sur la figure 7 , lorsque la tension de déchet Vce est régulée entre 0,3 et 0,4V (Zone C), le courant dans le second moyen de commutation 2B change peu, et le courant circulant dans le premier moyen de commutation 2A tend à augmenter.

Enfin, lorsque la tension de déchet Vce est supérieure à 0,4V (Zone A), le courant dans le premier moyen de commutation 2A n'augmente plus, et le surplus de courant supplémentaire circule dans le second moyen de commutation 2B. Dans cette dernière configuration, le courant électrique dans le premier moyen de commutation 2A est environ égal au courant nominal In, et le courant dans le second moyen de commutation 2B environ égal à (Ic-In).

## Revendications

1. Commutateur statique (1) haute tension destiné à être connecté en série avec une charge (3) à protéger, ce commutateur comportant :
- au moins deux moyens de commutation électrique (2A, 2B) connectés en parallèle, les deux moyens de commutation étant de technologie différente,
- des moyens de mesure (4) destinés à mesurer une tension électrique aux bornes des moyens de commutation électrique 2A, 2B et un courant principal (Ic) circulant dans la charge (3), et
- des moyens de commande (5) connectés au moyens de mesure (4) et délivrant un signal de commande (Vcom, Ib) pour agir sur l'ouverture et la fermeture des moyens de commutation électrique (2A, 2B) en fonction de la valeur du courant électrique principal (Ic) traversant la charge (3),
**caractérisé en ce que** :
- le premier moyen de commutation (2A) comporte un premier transistor de type bipolaire (T1) connecté en série avec un second transistor à effet de champ (T2), l'émetteur (E) du premier transistor de type bipolaire (T1) étant relié au drain (D) du second transistor à effet de champ (T2),
- les moyens de commande (5) sont connectés :
- à la base du premier transistor de type bipolaire (T1) pour y délivrer un courant de commande (Ib) régulé,
- à la grille du second transistor à effet de champ (T2) pour y délivrer une tension de commande Vcom,
- les moyens de commande (5) sont aptes à délivrer à la base du premier transistor de type bipolaire (T1) ledit courant de commande (Ib) régulé et dépendant à la fois d'une tension de référence (Vref), du courant électrique principal (Ic) et d'une tension de déchet (Vcs) mesurée entre le collecteur (C) du premier transistor de type bipolaire (T1) et la source (S) du second transistor à effet de champ de type MOSFET (T2), et
- les moyens de commande (5) étant ainsi connectés au premier moyen de commutation électrique (2A) de manière à ce que l'état de conduction dudit premier moyen de commutation dépende à la fois du courant de commande régulé (Ib) et de la tension de commande (Vcom) délivrés par lesdits moyens de commande (5).

2. Commutateur statique (1) haute tension destiné à être connecté en série avec une charge (3) à protéger, ce commutateur comportant :
- au moins deux moyens de commutation électrique (2A, 2B) connectés en parallèle, les deux moyens de commutation étant de technologie différente,
- des moyens de mesure (4) destinés à mesurer une tension électrique aux bornes des moyens de commutation électrique 2A, 2B et un courant principal (Ic) circulant dans la charge (3), et
- des moyens de commande (5) connectés au moyens de mesure (4) et délivrant un signal de commande (Vcom, Ib) pour agir sur l'ouverture et la fermeture des moyens de commutation électrique (2A, 2B) en fonction de la valeur du courant électrique principal (Ic) traversant la charge (3),
**caractérisé en ce que** :
- le premier moyen de commutation (2A) comporte un transistor de type ESBT,
- les moyens de commande (5) sont connectés :
- à la base du transistor de type ESBT pour y délivrer un courant de commande (Ib) régulé,
- entre la base et la source dudit transistor pour y délivrer une tension de commande (Vcom),
- les moyens de commande (5) sont aptes à délivrer à la base du premier transistor de type ESBT ledit courant de commande (Ib) régulé et dépendant à la fois d'une tension de référence (Vref), du courant électrique principal (Ic) et d'une tension de déchet (Vcs) mesurée entre le collecteur (C) et la source dudit transistor de type ESBT, et
- les moyens de commande (5) sont ainsi connectés au premier moyen de commutation électrique (2A) de manière à ce que l'état de conduction dudit premier moyen de commutation dépende à la fois du courant de commande régulé (Ib) et de la tension de commande (Vcom) délivrés par lesdits moyens de commande (5).

3. Commutateur statique selon l'une des revendications précédentes, **caractérisé en ce que** le second moyen de commutation électrique (2B) comporte un troisième transistor (T3), les moyens de commande (5) étant connectés audit transistor pour y délivrer une tension de commande (Vcom).

4. Commutateur statique selon la revendication 3, **caractérisé en ce que** le troisième transistor (T3) est un transistor bipolaire à grille de type IGBT, les moyens de commande (5) étant connectés à la grille dudit transistor bipolaire à grille de type IGBT pour y délivrer une tension de commande (Vcom).

5. Commutateur statique selon la revendication 3, **caractérisé en ce que** le troisième transistor (T3) est un transistor à effet de champ de type MOSFET, les moyens de commande (5) étant connectés à la grille dudit transistor à effet de champ pour délivrer une tension de commande (Vcom).

6. Commutateur statique selon l'une quelconque des revendications précédentes, dans lequel les moyens de commande (5) sont aptes à délivrer à la base du premier transistor (T1) ledit courant de commande (Ib), ce courant de commande (Ib) suivant une variation proportionnelle à la valeur du courant principal (Ic) et ce courant de commande (Ib) étant maintenu inférieur au rapport Ic/Hfe entre le courant principal (Ic) et le gain (Hfe) du premier transistor (T1).

## Patentansprüche

1. Statischer Hochspannungsschalter (1), der dazu bestimmt ist, mit einer zu schützenden Last (3) in Reihe geschaltet zu werden, wobei dieser Schalter aufweist:
- mindestens zwei parallelgeschaltete elektrische Schalteinrichtungen (2A, 2B), wobei die zwei Schalteinrichtungen von unterschiedlicher Technologie sind,
- Messeinrichtungen (4), die dazu bestimmt sind, eine elektrische Spannung an den Klemmen der elektrischen Schalteinrichtungen (2A, 2B) und einen in der Last (3) fließenden Hauptstrom (Ic) zu messen, und
- Steuereinrichtungen (5), die mit den Messeinrichtungen (4) verbunden sind und ein Steuersignal (Vcom, Ib) liefern, um auf das Öffnen und Schließen der Schalteinrichtungen (2A, 2B) abhängig vom Wert des die Last (3) durchquerenden elektrischen Hauptstroms (Ic) einzuwirken,
**dadurch gekennzeichnet, dass**:
- die erste Schalteinrichtung (2A) einen ersten Transistor vom Bipolartyp (T1) in Reihe geschaltet mit einem zweiten Feldeffekttransistor (T2) aufweist, wobei der Emitter (E) des ersten Transistors vom Bipolartyp (T1) mit dem Drain (D) des zweiten Feldeffekttransistors (T2) verbunden ist,
- die Steuereinrichtungen (5) verbunden sind:
- mit der Basis des ersten Transistors vom Bipolartyp (T1), um dahin einen geregelten Steuerstrom (Ib) zu liefern,
- mit dem Gate des zweiten Feldeffekttransistors (T2), um dahin eine Steuerspannung Vcom zu liefern,
- die Steuereinrichtungen (5) an die Basis des ersten Transistors vom Bipolartyp (T1) den Steuerstrom (Ib) liefern können, der geregelt ist und zugleich von einer Bezugsspannung (Vref), vom elektrischen Hauptstrom (Ic) und von einer Abschaltspannung (Vcs) abhängt, die zwischen dem Kollektor (C) des ersten Transistors vom Bipolartyp (T1) und der Source (S) des zweiten Feldeffekttransistors vom Typ MOSFET (T2) gemessen wird, und
- die Steuereinrichtungen (5) so mit der ersten elektrischen Schalteinrichtung (2A) verbunden sind, dass der Leitzustand der ersten Schalteinrichtung zugleich vom geregelten Steuerstrom (Ib) und von der Steuerspannung (Vcom) abhängt, die von den Steuereinrichtungen (5) geliefert werden.

2. Statischer Hochspannungsschalter (1), der dazu bestimmt ist, mit einer zu schützenden Last (3) in Reihe geschaltet zu werden, wobei dieser Schalter aufweist:
- mindestens zwei parallelgeschaltete elektrische Schalteinrichtungen (2A, 2B), wobei die zwei Schalteinrichtungen von unterschiedlicher Technologie sind,
- Messeinrichtungen (4), die dazu bestimmt sind, eine elektrische Spannung an den Klemmen der elektrischen Schalteinrichtungen (2A, 2B) und einen in der Last (3) fließenden Hauptstrom (Ic) zu messen, und
- Steuereinrichtungen (5), die mit den Messeinrichtungen (4) verbunden sind und ein Steuersignal (Vcom, Ib) liefern, um auf das Öffnen und Schließen der elektrischen Schalteinrichtungen (2A, 2B) abhängig vom Wert des die Last (3) durchquerenden elektrischen Hauptstroms (Ic) einzuwirken,
**dadurch gekennzeichnet, dass**:
- die erste Schalteinrichtung (2A) einen Transistor vom Typ ESBT aufweist,
- die Steuereinrichtungen (5) verbunden sind:
- mit der Basis des Transistors vom Typ ESBT, um dahin einen geregelten Steuerstrom (Ib) zu liefern,
- zwischen der Basis und der Source des Transistors, um dahin eine Steuerspannung (Vcom) zu liefern,
- die Steuereinrichtungen (5) an die Basis des ersten Transistors vom Typ ESBT den Steuerstrom (Ib) liefern können, der geregelt ist und zugleich von einer Bezugsspannung (Vref), vom elektrischen Hauptstrom (Ic) und von einer Abschaltspannung (Vcs) abhängt, die zwischen dem Kollektor (C) und der Source des Transistors vom Typ ESBT gemessen wird, und
- die Steuereinrichtungen (5) so mit der ersten elektrischen Schalteinrichtung (2A) verbunden werden, dass der Leitzustand der ersten Schalteinrichtung zugleich vom geregelten Steuerstrom (Ib) und von der Steuerspannung (Vcom) abhängt, die von den Steuereinrichtungen (5) geliefert werden.

3. Statischer Schalter nach einem der vorhergehenden Ansprüche, **dadurch gekennzeichnet, dass** die zweite elektrische Schalteinrichtung (2B) einen dritten Transistor (T3) aufweist, wobei die Steuereinrichtungen (5) mit dem Transistor verbunden sind, um dahin eine Steuerspannung (Vcom) zu liefern.

4. Statischer Schalter nach Anspruch 3, **dadurch gekennzeichnet, dass** der dritte Transistor (T3) ein Bipolartransistor mit isolierter Gate-Elektrode vom Typ IGBT ist, wobei die Steuereinrichtungen (5) mit dem Gate des Bipolartransistors mit isolierter Gate-Elektrode vom Typ IGBT verbunden sind, um dahin eine Steuerspannung (Vcom) zu liefern.

5. Statischer Schalter nach Anspruch 3, **dadurch gekennzeichnet, dass** der dritte Transistor (T3) ein Feldeffekttransistor vom Typ MOSFET ist, wobei die Steuereinrichtungen (5) mit dem Gate des Feldeffekttransistors verbunden sind, um eine Steuerspannung (Vcom) zu liefern.

6. Statischer Schalter nach einem der vorhergehenden Ansprüche, wobei die Steuereinrichtungen (5) den Steuerstrom (Ib) an die Basis des ersten Transistors (T1) liefern können, wobei dieser Steuerstrom (Ib) einer Änderung proportional zum Wert des Hauptstroms (Ic) folgt, und dieser Steuerstrom (Ib) niedriger als das Verhältnis Ic/Hfe zwischen dem Hauptstrom (Ic) und dem Gain (Hfe) des ersten Transistors (T1) gehalten wird.

## Claims

1. High-voltage solid-state switch (1) that is intended to be connected in series with a load (3) to be protected, this switch including:
- at least two electrical switching means (2A, 2B) that are connected in parallel, the two switching means being based on different technology;
- measurement means (4) that are intended to measure a voltage across the terminals of the electrical switching means 2A, 2B and a main current (Ic) flowing through the load (3); and
- control means (5) that are connected to the measurement means (4) and that deliver a control signal (Vcom, Ib) to act on the opening and the closing of the electrical switching means (2A, 2B) according to the value of the main electric current (Ic) flowing through the load (3),
**characterized in that**:
- the first switching means (2A) includes a first, bipolar transistor (T1) that is connected in series with a second, field-effect transistor (T2), the emitter (E) of the first, bipolar transistor (T1) being linked to the drain (D) of the second, field-effect transistor (T2);
- the control means (5) are connected:
- to the base of the first, bipolar transistor (T1) to deliver a regulated control current (Ib) thereto;
- to the gate of the second, field-effect transistor (T2) to deliver a control voltage Vcom thereto;
- the control means (5) are suitable for delivering, to the base of the first, bipolar transistor (T1), said regulated control current (Ib) that is dependent on a reference voltage (Vref), on the main electric current (Ic) and on a waste voltage (Vcs) that is measured between the collector (C) of the first, bipolar transistor (T1) and the source (S) of the second, MOS field-effect transistor (T2); and
- the control means (5) thus being connected to the first electrical switching means (2A) such that the conduction state of said first switching means depends both on the regulated control current (Ib) and on the control voltage (Vcom) that are delivered by said control means (5).

2. High-voltage solid-state switch (1) that is intended to be connected in series with a load (3) to be protected, this switch including:
- at least two electrical switching means (2A, 2B) that are connected in parallel, the two switching means being based on different technology;
- measurement means (4) that are intended to measure a voltage across the terminals of the electrical switching means 2A, 2B and a main current (Ic) flowing through the load (3); and
- control means (5) that are connected to the measurement means (4) and that deliver a control signal (Vcom, Ib) to act on the opening and the closing of the electrical switching means (2A, 2B) according to the value of the main electric current (Ic) flowing through the load (3),
**characterized in that**:
- the first switching means (2A) includes an emitter-switched bipolar transistor (ESBT);
- the control means (5) are connected:
- to the base of the emitter-switched bipolar transistor (ESBT) to deliver a regulated control current (Ib) thereto;
- between the base and the source of said transistor to deliver a control voltage (Vcom) thereto;
- the control means (5) are suitable for delivering, to the base of the first, emitter-switched bipolar transistor (ESBT), said regulated control current (Ib) that is dependent on a reference voltage (Vref), on the main electric current (Ic) and on a waste voltage (Vcs) that is measured between the collector (C) and the source of said emitter-switched bipolar transistor (ESBT); and
- the control means (5) thus being connected to the first electrical switching means (2A) such that the conduction state of said first switching means depends both on the regulated control current (Ib) and on the control voltage (Vcom) that are delivered by said control means (5).

3. Solid-state switch according to one of the preceding claims, **characterized in that** the second electrical switching means (2B) includes a third transistor (T3), the control means (5) being connected to said transistor to deliver a control voltage (Vcom) thereto.

4. Solid-state switch according to Claim 3, **characterized in that** the third transistor (T3) is an insulated-gate bipolar transistor (IGBT), the control means (5) being connected to the gate of said insulated-gate bipolar transistor (IGBT) to deliver a control voltage (Vcom) thereto.

5. Solid-state switch according to Claim 3, **characterized in that** the third transistor (T3) is a MOS field-effect transistor, the control means (5) being connected to the gate of said field-effect transistor to deliver a control voltage (Vcom).

6. Solid-state switch according to one of the preceding claims, wherein the control means (5) are suitable for delivering, to the base of the first transistor (T1), said control current (Ib), this control current (Ib) varying proportionally to the value of the main current (Ic) and this control current (Ib) being kept lower than the ratio Ic/Hfe of the main current (Ic) to the gain (Hfe) of the first transistor (T1).
